(19) Europäisches Patentamt
European Patent Office
Office européen des brevets

(11) Publication number: **0 154 512 B1**

(12) **EUROPEAN PATENT SPECIFICATION**

(45) Date of publication of patent specification: 24.04.91    (51) Int. Cl.⁵: **G03F 7/027, C08F 287/00**

(21) Application number: **85301350.6**

(22) Date of filing: **28.02.85**

The file contains technical information submitted
after the application was filed and not included in
this specification

(54) Tapered di-block copolymer photopolymerizable composition.

(30) Priority: **06.03.84 US 586588**

(43) Date of publication of application:
**11.09.85 Bulletin 85/37**

(45) Publication of the grant of the patent:
**24.04.91 Bulletin 91/17**

(84) Designated Contracting States:
**DE FR GB IT NL**

(56) References cited:
**FR-A- 2 415 325**
**US-A- 3 317 918**
**US-A- 4 162 919**
**US-A- 4 323 637**

(73) Proprietor: **W.R. Grace & Co.-Conn. (a Connecticut corp.)**
**Grace Plaza 1114 Avenue of the Americas**
**New York New York 10036(US)**

(72) Inventor: **Farber, Milton**
**Deerfield Lane**
**Bethany New Haven Connecticut(US)**

(74) Representative: **Browne, Robin Forsythe et al**
**Urquhart-Dykes & Lord Tower House Merrion Way**
**Leeds LS2 8PA West Yorkshire(GB)**

## Description

BACKGROUND OF THE INVENTION

### 1. Field of the Invention

The present invention relates to a photopolymer elastomeric article which is designed to be used in a flexographic printing system. Flexographic printing is a method of rotary letterpress printing which employs flexible elastomer printing plates. In this system the ink is transferred directly from the raised surfaces of the elastomeric plate to the printing stock. Those properties most desirable in flexible photopolymer plates include resistance to the wide variety of solvents used in printing inks, good ink transfer from plate to substrate, proper hardness (durometer), short plate processing time, resistance to ozone and oxidative cracking, and resistance to post-hardening.

### 2. References of Interest

Flexible photopolymer printing plates are usually made of:
1. An elastomeric polymer matrix;
2. A photopolymerizable, ethylenically unsaturated crosslinking agent, as typified by esters of acrylic or methacrylic acid, and
3. A photoinitiator, which is a compound, which when irradiated, will initiate polymerization and/or crosslinking.

The use of copolymers of dienes as an elastomeric polymer matrix, including those of the tri-block (A-B-A) variety which are thermoplastic elastomers such as Kraton [trademark], is well known.

U.S. Patent 3,024,180 and Canadian Patent 614,181 disclose photopolymer compositions based on polymers of 1,3-butadiene and halogen-substituted 1,3-butadiene, with the U.S. patent also mentioning copolymers of the butadiene with aryl olefins such as styrene.

U.S. Patent 3,674,486 discloses printing plate compositions based on tri-block copolymers of styrene (S) and butadiene (B) or isoprene (I) of structure S-B-S or S-I-S.

U.S. Patents 4,323,636 and -637 also disclose printing plate compositions based on tri-block copolymers of styrene with butadiene or isoprene (S-B-S or S-I-S).

U.S. Patent 4,045,231 discloses a photosensitive resin composition for flexographic printing plates comprising (a) styrene- butadiene tri-block copolymers of the S-B-S type; (b) at least one liquid prepolymer having a molecular weight of 1,000 to 5,000 selected from the group consisting of polybutadiene and butadiene- styrene copolymer; (c) monomer containing at least one vinyl group such as glycol methacrylates; and (d) a photopolymerization initiator such as benzophenone. US-A-4162919 provides an elastomeric composition comprising

(i) a non- elastomeric tapered di-block copolymer of a $C_8$-$C_{12}$ vinyl aromatic hydrocarbon and a $C_4$-$C_8$ diene hydrocarbon;
(ii) an ethylenically unsaturated photopolymerizable crosslinking agent, and
(iii) an effective amount of an addition polymerization initiator activatable by actinic radiation.
However, in practice only relatively high Shore A hardness values are obtainable by this process.

The present invention is characterised in that the vinyl aromatic hydrocarbon is present at 3.5 to 15% by weight of the tapered di-block copolymer and in that said photopolymerizable elastomeric composition when cured by exposure to actinic radiation through an image-bearing process transparency containing both substantially clear and opaque areas, produces portions of the compositions beneath the clear area which are insoluble in halogenated hydrocarbon and which have a hardness of 42 or less Shore A.

For conversion to a flexographic printing plate, a layer of the photopolymerizable composition of this invention, adhered to a backing layer, is exposed to actinic radiation through an image-bearing process transparency containing substantially clear and opaque areas and placed in intimate contact with the photopolymerizable layer.

Irradiation causes insolubilization in the area of the layer underneath the clear area of the process transparency, but substantially no insolubilization occurs in the unexposed areas underneath the opaque areas of the process transparency. After the irradiation, the article is treated with a solvent for the polymer matrix such as a halogenated hydrocarbon which removes the unexposed soluble areas of the plate. The resulting relief surface, after drying, can now be used for printing, either as a plate or in sleeve form.

The ability to employ polybutadiene or styrene-butadiene copolymer elastomers for the production of photopolymer compositions and specifically flexographic printing plates is highly desirable, since these elastomers are relatively inexpensive. Their shortcomings, however, namely difficult processability as well as poor tensile properties and low resistance to cold flow in the uncured state have heretofore precluded such use. Resort has been had to the so-called thermoplastic elastomers, which have been described as being rubber-like at room temperature but thermoplastic at elevated temperatures so that they can be processed by conventional plastics technology. Such a material which has been frequently mentioned in the literature is a styrene-butadiene or styrene-isoprene block copolymer of the tri-block A-B-A type. The B mid-block is the polydiene and comprises 70 to 90% of the weight of the polymer, with the A end-blocks being polystyrene. Photopolymer compositions made with these tri-block copolymers, however, even with the molecule being mainly elastomeric mid-block, when they are cured tend to be hard and resinous at room temperature and below. This is detrimental to good printing, particularly when the substrate to be printed upon is uneven and rough, as is the case with corrugated paper sheets used in packaging. A desirable range of hardness for flexographic printing plates is 30 to 45 Shore A. With typical photocured compositions based on commercially available S-B-S types, hardnesses of 70 or higher Shore A are common, and with the softer S-I-S type containing as little as 14% total polystyrene, hardnesses of 50 or higher Shore A are usually produced.

Although plasticizers and low molecular weight liquid rubbers may be used to decrease the hardness, these are undesirable in that they are costly, lower physical properties and can-be leached out during processing and printing.

A di-block copolymer has an A-B structure, and a tapered di-block is one in which the linkage between the A and B units is a copolymer which is initially richer in A than B but becomes richer in B. The symbol A B has been proposed for such a link and thus the total tapered di-block copolymer can be illustrated by A-(A B)-B.

The tapered di-block copolymer of the present invention contains a first block which is an elastomeric diene polymer and a second block which is a vinyl aromatic non-elastomeric thermoplastic polymer. Between the two blocks is interposed a segment which is a copolymer initially richer in the diene component but becomes richer in the vinyl aromatic component, hence the term "tapered" di-block. When the tapered di-block copolymer contains 5-20% of the vinyl aromatic component it is elastomeric at room temperature and is classified as an elastomer. It will have a single glass transition temperature (Tg), one which is close to that of the polydiene elastomer block and below $0°$C. The tri-block copolymers, however, usually possess two Tg's, a high temperature one characteristic of the resinous thermoplastic end-blocks (above $25°$C) and a low temperature Tg characteristic of the elastomeric mid-block (below $10°$C). In the most frequent embodiments of this type of copolymer, namely the S-S-S and S-I-S types, the high temperature Tg is ca $100°$C, characteristic of polystyrene and the low temperature one is ca $-95°$C characteristic of polybutadiene or polyisoprene, respectively. Before this type of material can be processed, the high temperature Tg must be surpassed.

By this criterion, although the tapered di-block co-polymer thus appears to be a conventional elastomer, in the same class as styrene-butadiene random copolymers or polybutadiene, it surprisingly forms a photopolymer composition of excellent quality. It can be blended with ethylenically unsaturated photopolymerizable crosslinking agent and photoinitiator at relatively low temperature and can be readily cast, molded, extruded or otherwise thermoformed. The product resulting therefrom is amenable to handling by ordinary techniques without undesirable cold flow. It may then be converted to a flexographic printing plate by the irradiation and wash-out procedure previously described. The resultant plate is soft, resilient and yields high quality printing even on corrugated sheet substrates.

## DESCRIPTION OF THE PREFERRED EMBODIMENTS OF THE INVENTION

The soft resilient compositions of the present invention comprise three major elements: (1) at least 70% of a tapered di-block copolymer containing 3.5 to 15% of a vinyl aromatic hydrocarbon component (component "A") and 85 to 96.5% elastomeric diene component (component "B"); (2) at least 1% of an ethylenically unsaturated photopolymerizable crosslinking agent; (3) a polymerization- effective amount of an addition polymerization initiator activatable by actinic radiation. Adjuvants such as coloring agents, heat stabilizers, plasticizers and processing aids may also be included. The tapered di-block copolymers useful in this invention have the general formula A-(A B)-B, as previously described. They are usually prepared by anionic polymerization utilizing a lithium base catalyst. The number average molecular weight ($M_n$) of the copolymer is from 25,000 to 2,000,000 and the polydispersity index ($M_w/M_n$) is 1.5-4, preferably 2.0-3.0%, where $M_w$ is weight average molecular weight. They are further characterized by a cis-1,4 structure of at least 29% and a 1,2-structure not in excess of 15%. Such materials are described in U.S. Patent 3,317,918 (Foster).

The elastomeric block of the tapered di-block copolymer is a polymer of a $C_4$-$C_6$ aliphatic conjugated diolefin, preferably butadiene or isoprene. The non-elastomeric block is a polymer of a $C_8$-$C_{12}$ vinyl aromatic hydrocarbon preferably styrene, alpha-methylstyrene, or vinyltoluene.

The non-elastomeric block is present as 3.5-15%, preferably 5-10% by weight of the tapered di-block copolymer.

The photopolymerizable ethylenically unsaturated crosslinking agents suitable for use in the invention include unsaturated esters of polyols, particularly such esters with alpha-methylene carboxylic acids, e.g. ethylene glycol diacrylate, diethylene glycol diacrylate, glycerol diacrylate, glycerol triacrylate, mannitol polyacrylate, sorbitol polyacrylate, ethylene glycol dimethacrylate, 1,3-propanediol dimethacrylate, 1,2,4-butanetriol trimethacrylate, 1,4-butanediol diacrylate and dimethacrylate, 1,4-cyclohexanediol diacrylate, 1,4-benzenediol dimethacrylate, isosorbidene diacrylate, pentaerythritol di-, tri-, and tetra-methacrylates, dipentaerythritol polyacrylate, pentaerythritol di-, tri-, and tetraacrylates, 1,3-propanediol diacrylate, 1,6-hexanediol diacrylate and dimethacrylate, 1,5-pentanediol dimethacrylate, trimethylolpropane triacrylate and trimethacrylate, and bisacrylates and-methacrylates of polyethylene glycols of molecular weight 200 to 4000; unsaturated amides, particularly those of the alpha-methylene carboxylic acids, and especially those of alpha, omega-diamines and oxygen-interrupted omega-diamines such as methylene bisacrylamide, methylene bis-methacrylamide, ethylene bis-methacrylamide, 1,6-hexamethylene bis-acrylamide, diethylenetriamine tris-methacrylamide, 1,2-di(gamma-methacrylamidopropoxy)ethane, beta-methacrylamidoethyl methacrylate, N-(beta-hydroxyethyl)-2-(methacrylamido)ethyl acrylate and N,N-bis-(beta-methacrylyloxyethyl) acrylamide; vinyl esters such as divinyl succinate, divinyl adipate, divinyl phthalate, divinyl terephthalate, divinylbenzene-1,3-disulfonate, divinylbutane-1,4-disulfonate and unsaturated aldehydes, such as sorbaldehyde (hexadienal). In addition to photopolymerization and crosslinking capability, the major requirement for the above materials is one of sufficient compatibility with the polymer matrix to avoid excessive light scattering of the actinic radiation used to cure the composition and permit attainment of useable tensile properties in the cured article.

As preferred photopolymerizable ethylenically unsaturated crosslinking agents there are the esters of polyols with unsaturated alpha-methylene carboxylic acids including 1,4-butanediol diacrylate and dimethacrylate, 1,6-hexanediol diacrylate and dimethacrylate and trimethylolpropane triacrylate and trimethacrylate. The amount of these materials may range from 1% to 30% with 5 to 20% preferred.

The addition polymerization and/or crosslinking initiators useful in the present invention are those activatable by actinic light and thermally inactive at and below 185° C. These include aromatic ketones such as benzophenone and substituted benzophenones, the substituted or unsubstituted polynuclear quinones, which are compounds having two intracyclic carbonyl groups attached to intracyclic carbon atoms in a conjugated six-membered carbocyclic ring, there being at least one aromatic carbocyclic ring fused to the ring containing the carbonyl groups. Suitable such initiators include 9,10-anthraquinone, 1-chloroanthraquinone, 2-chloroanthraquinone, 2-methylanthraquinone, 2-tert-butylanthraquinone, octamethylanthraquinone, 1,4-naphthoquinone, 9,10-phenanthrenequinone, 1,2-benzanthraquinone, 2,3-benzanthraquinone, 2-methyl-1,4-naphthoquinone, 2,3-dichloronaphthoquinone, 1,4-dimethylanthraquinone, 2,3-dimethylanthraquinone, 2-phenylanthraquinone, 2,3-diphenylanthraquinone, sodium salt of anthraquinone alpha-sulfonic acid, 3-chloro-2-methylanthraquinone, alpha-retenequinone, 7,8,9,10- tetrahydronaphthacenequinone, and 1,2,3,4-tetrahydrobenzaanthracene-7-12-dione. Other photoinitiators which are also useful are described in U.S. Patent 2,760,863 and include vicinal ketaldonyl compounds, such as diacetyl, benzil, etc; alpha-ketaldonyl alcohols, such as benzoin, pivaloin, etc., acyloin ethers, e.g. benzoin methyl and ethyl ethers, etc., alpha-hydrocarbon substituted aromatic acyloins, including alpha-methylbenzoin, alpha-allylbenzoin, alpha- phenylbenzoin and 2,2-dialkoxy-2-phenylacetophenones. Preferred initiators include 2,2-dimethoxy-2-phenylacetophenone, $C_1$ to $C_5$ alkyl ethers of benzoin, and benzophenone. Concentration range may be 0.1 to 5%, with 1 to 3% being preferred.

Resistance of photosensitive elements of this invention and printing reliefs made therefrom to oxygen and ozone attack can be improved by incorporating in the photosensitive composition a suitable amount of compatible antioxidants and/or antiozonants. Antioxidants useful in this invention include: alkylated phenols, e.g., 2,6-di-tert-butyl-4-methylphenol; alkylated bis-phenols, e.g., 2,2-methylene-bis-(4-methyl-6-tert-butylphenol); tetrakis-methylene-3-(3',5'-di-t-butyl-4'-hydroxyphenyl)propionate methane; 2-(4-hydroxy-3,5-tert-butylanilino)-4,6-bis-(n-octylthio)-1,3-,5-triazone; polymerized trimethyl dihydroquinone; zinc dibutyl dithiocarbonate; and dilaurylthiodipropionate. Antiozonants useful in this invention include:

microcrystalline wax and paraffin wax; dibutyl thiourea; 1,1,3,3-tetramethyl-2-thiourea; Antiozonant AFD, a product of Nafton Co.; norbornenes, e.g., di-5-norbornene-2-methyl adipate, di-5-norbornene-2-methyl maleate, di-5-norbornene-2-methyl terephthalate, etc.; Ozone Protector 80, a product of Reichhold Chemical Co.; N-phenyl-2-naphthylamine; unsaturated vegetable oils, e.g., rapeseed oil, linseed oil, safflower oil, etc.; polymers and resins, e.g., ethylene-vinyl acetate copolymer resin, chlorinated polyethylene, chlorosulfonated polyethylene, chlorinated ethylene-methacrylic acid copolymer, polyurethanes, polypentadienes, polybutadiene, furfural derived resins, ethylene propylene diene rubber, diethylene glycol ester of resin, and alpha-methyl styrene-vinyl toluene copolymer.

The photosensitive composition can be prepared by mixing the elements either in solution, on an open mill, in an extruder or in an internal mixer for a time long enough to incorporate the ingredients homogeneously, usually several minutes. The composition can then be cast, compression molded or extruded to the desired thickness in sheet or sleeve form. It is irradiated through a black and white transparency with a high intensity UV source for a time sufficient to cure the exposed areas, leaving them solvent resistant. The unexposed areas are then removed by brushing or washing with solvents, leaving the crosslinked insoluble polymer network as the relief plate image. The plate is then dried in a forced air oven.

The supporting substrate for the photosensitive compound must be dimensionally stable and solvent resistant. Commonly used supports are sheet metals, such as aluminum, and plastics in sheet form, such as polyester and polyamide. The following examples illustrate the invention without limiting its scope.

In the examples below, certain ingredients were employed which are characterized as follows:

Polymers

| | |
|---|---|
| DBSB-I: | Tapered di-block styrene (10%)-butadiene (90%) copolymer; styrene block = 7%; ML-4 at $100°C$ = 35; $M_n$ = 83,000; Tg = 92°C; sold as Stereon [trademark] 720A. |
| DBSB-II: | Tapered di-block styrene (30%)-butadiene (70%) copolymer; styrene block = 21%; $M_n$ = 140,000; sold as Stereon 730A (outside the composition of this invention). |
| TNSB-I: | Triblock (S-B-S) styrene (28%)-butadiene (72%) copolymer; sold as Kraton [trademark] 1102 (outside the composition of this invention). |
| TNSB-II: | Triblock (S-I-S) styrene (14%)-isoprene (86%) copolymer; sold as Kraton 1107; (outside the composition of this invention). |

Crosslinking agents

| | |
|---|---|
| HDDM: | 1,6-hexanediol dimethacrylate |
| HDDA: | 1,6-hexanediol diacrylate |
| TMPM: | Trimethylolpropane trimethacrylate |
| TMPA: | Trimethylolpropane triacrylate |

Initiators

| | |
|---|---|
| DPAP: | 2,2-dimethoxy-2-phenylacetophenone; sold as Irgacure [trademark] 651 |

Stabilizers

| | |
|---|---|
| TKPM: | Tetrakismethylene 3-(3,5-di-t-butyl-4-hydroxyphenyl) propionate methane; sold as Irganox [trademark] 1010. |
| BHT: | 2,6-di-t-butyl-4-methylphenol |
| AMVT: | Alpha-methylstyrene-vinyl toluene copolymer |

EXAMPLE 1

The tapered di-block styrene-butadiene copolymer DBSB-I was mixed on a two roll mill at 90-100°C with the ingredients shown below.

|  | (Weights in grams) | | |
|---|---|---|---|
|  | A | B | C |
| DBSB-I copolymer | 150 | 150 | 150 |
| HDDM | 15 | 22.5 | 30 |
| DPAP | 3 | 3 | 3 |
| TKPM | 0.2 | 0.2 | 0.2 |

All the ingredients milled together smoothly and readily. The mixtures were then compression molded into 17.78mm (0.070")sheets between a transparent 0.127mm(0.005") polyester film support and a matte 0.127mm(0.005") polyester removable cover sheet. The molded products could be handled by conventional procedures without distortion and did not show appreciable cold flow when stored at room temperature.

Sheets of the mixtures were then exposed through the clear back sides (the polyester film support) to ultraviolet radiation for 15 to 20 seconds, using a "black light" exposure unit. The cover sheets were then removed and the face sides of the sheets were exposed through a black and white transparency for 9 to 11 minutes in the same exposure unit. The transparency had solid open areas, fine lines and half-tones on it. The unexposed areas were then washed out with 95/5 perchloroethylene/n-butanol in a rotating brush wash unit and the plate dried at 65° C. The finished plates showed good resolution, straight fine lines, 0.78mm-(0.031") to 0.91mm(0.36") relief, and Shore A hardnesses of 31, 34, and 32 respectively for A, B and C. The cured compositions were transparent and almost colorless.

EXAMPLE 2

The formula of Example 1 was repeated substituting for the HDDM the following combinations of HDDM with 1,6-hexanediol diacrylate (HDDA):

|  | (Weights in grams) | | | |
|---|---|---|---|---|
|  | A | B | C | D |
| HDDA | 1.5 | 3 | 7.5 | 9 |
| HDDM | 13.5 | 12 | 7.5 | 6 |

All of these compositions could be blended together readily and smoothly on a two roll mill at 90°-100°C and compression molded into 17.78mm(0.070") plates as in Example 1. These plates could be handled by conventional procedures without distortion and did not show appreciable cold flow when stored at room temperature.

They were then given back side ultraviolet exposures of 15 to 20 seconds and face exposures with cover sheet removed through a black and white transparency for 7 to 11 minutes followed by solvent washing and drying as in Example 1. The finished plates possessed good resolution, straight fine lines, 0.6mm(0.024") to 0.86mm(0.034") relief and Shore A hardnesses of 34, 33, 38 and 35 respectively for A, B, C and D. The cured plates were clear, transparent and almost colorless.

EXAMPLE 3

The formula of Example 1 was repeated, substituting for the HDDM the following:

|  | (Weights in grams) | | |
|---|---|---|---|
|  | A | B | C |
| Trimethylolpropane Trimethacrylate (TMPM) | 15 | – | 12 |
| Trimethylolpropane Triacrylate (TMPA) | – | 15 | 3 |

The mixtures were processed as in Example 1, including mixing, compression molding, UV exposures, solvent wash-out and drying. The finished plates were of high quality and showed Shore A hardnesses of 34, 42 and 38 respectively for A, B and C.

## EXAMPLE 4

The following composition was mixed on a two roll mill at 90°C-100°C, and compression molded into 17.78mm(0.070") plates as in Example 1.

| | (Weights in grams) |
|---|---|
| DBSB-I copolymer | 150 |
| HDDM | 30 |
| DPAP | 3 |
| BHT | 1.5 |
| Calcium stearate | 0.3 |
| TKPM | 0.1 |
| Microcrystalline wax | 3 |
| AMVT | 7.5 |

After UV exposure (15 seconds back side, 12 minutes face side through a black and white transparency), wash-out and drying as in Example 1, a high quality finished plate with 0.91mm(0.036") relief was obtained. Its Shore A hardness was 39. A portion of this plate was exposed to 50 parts/hundred million of ozone at 100°C for 200 hours with no appreciable surface damage or cracking. A compound similar to this one but lacking the microcrystalline wax and alpha-methylstyrene-vinyltoluene copolymer showed severe damage after 10 hours ozone exposure.

## EXAMPLE 5

The following composition was mixed with a sigma blade internal mixer at 120°-125°C.

| | (Weights in grams) |
|---|---|
| DBSB-I | 5,000 |
| HDDA | 300 |
| HDDM | 200 |
| DPAP | 100 |
| BHT | 50 |
| TKPM | 5 |
| Microcrystalline Wax | 100 |
| AMVT | 250 |

The mix was granulated and extruded at a melt temperature of 120°C-125°C through a 24:1 L/D (length to diameter ratio of extruder screw) extruder, through a 6.35mm(¼") slit die. The extrudate was smooth and clear, and the extruder barrel pressure did not exceed 70.3Kg/cm$^2$(1,000 psi). The extrudate was compression molded into plates and photoprocessed as in Example 1 (20 second back side and 10 minutes face side exposure through a black and white transparency). The resulting plate was clear, of high quality, and possessed 0.86mm(0.034") relief with a Shore A hardness of 38.

7

EXAMPLE 6

The composition of Example 5 was mixed by dissolving the components in a mixture of 3:1 toluene:methylethyl ketone at 30% total solids concentration.

The solution was then cast in successive layers on clear 0.127mm(0.005") polyester support sheet until a dried thickness of 1.7mm(0.067") was attained. Plates of this product were photoprocessed as in Example 1 (20 to 40 seconds back side, 4 to 6 minutes face side exposure through a black and white transparency, using high intensity "black light" lamps). In 100% perchloroethylene the wash-out rate was 10 mils/min. and in 75/25 perchloroethylene-n-butanol the rate was ca. 5 mils/min. The resultant printing plate was of high quality and when mounted on a printing press, gave clear, solid impressions with a black, water based ink with a Shore A hardness of 38.

Examples 7-9 Comparisons

Following essentially the procedures of Examples 1 (7 and 9) and 5 (8), certain tri-block polymers and another tapered di-block polymer were evaluated. Such tri-block-based photopolymers invariably exhibit relatively high hardness which is detrimental to good printing especially where the substrates are uneven or rough. The recipes, mixing/processing and curing conditions are summarized in the Table below (all ingredients in parts by weight):

| Example | 7 | 8* | 9 |
|---|---|---|---|
| TNSB-I | 100 | - | - |
| TNSB-II | - | 100 | - |
| DBSB-II | - | - | 100 |
| HDDA | 6.0 | 6.0 | 6.7 |
| HDDM | - | 4.0 | 3.35 |
| DPAP | 1.0 | 2.0 | 2.0 |
| Microcrystalline wax | - | 2.0 | - |
| AMVT | - | 5.0 | 2.0 |
| BHT | - | 1.0 | 1.0 |
| TKPM | 0.2 | 0.1 | 0.13 |
| Processing Temperature °C | 120 | 120-125 | 150 |
| Plate thickness, mm | 1.78 | 2.84 | 1.78 |
| U.V. Back side exposure, sec | 10 | 20 | 5 |
| U.V. Face side exposure, min | 6 | 10 | 5 |
| Shore A Hardness | 66 | 52 | 64 |

Remarks: *Substantially confirms Example 36 of U.S. Patent 4,323,637 (Chen et al.)

The results clearly indicate that the above polymers are deficient with regard to hardness development either because of their tri-block structure or because of too large a styrene block (greater than 15% of total copolymer).

Claims

EP 0 154 512 B1

1. An elastomeric composition comprising,
   (i) a non-elastomeric tapered di-block copolymer of a $C_8$-$C_{12}$ vinyl aromatic hydrocarbon and $C_4$-$C_6$ diene hydrocarbon,
   (ii) an ethylenically unsaturated photopolymerizable crosslinking agent, and
   (iii) an effective amount of an addition polymerization initiator activatable by actinic radiation; characterised in that the vinyl aromatic hydrocarbon is present at 3.5 to 15% by weight of the tapered di-block copolymer, and in that said photopolymerizable elastomeric composition when cured by exposure to actinic radiation through an image bearing process transparency containing both substantially clear and opaque areas, produces portions of the compositions beneath the clear area which are insoluble in halogenated hydrocarbon and which have a hardness of 42 or less Shore A.

2. A composition according to claim 1 characterised in that
   (i) said tapered di-block copolymer is at least 70%
   (ii) said cross-linking agent is at least 1% by weight, and
   (iii) said initiator is at least 0.1% by weight, all of the above based on the total weight of the composition.

3. A composition according to claim 2 characterised in that it further comprises from 1 to 5% of a microcrystalline wax and copolymer.

4. A composition according to claim 2 or 3 characterised in that the tapered di-block copolymer has a formula A-(A B)-B, a number average molecular weight from 25,000 to 2,000,000, a polydispersity index from 1.5 to 4.0, a cis-1,4- structure of at least 29%, and a 1,2- structure not in excess of 15%.

5. A composition according to claim 3 or 4 characterised in that the vinyl aromatic hydrocarbon is styrene, alpha-methylstyrene or vinyltoluene.

6. A composition according to any of claims 3 to 5 characterised in that the aliphatic conjugated diolefin is butadiene or isoprene.

7. A composition according to any of the preceding claims characterised in that the ethylenically unsaturated photopolymerisable crosslinking agent is 1,4- butanediol diacrylate, 1,4- butanediol dimethacrylate, 1,6-hexanediol diacrylate, 1,6- hexanediol dimethacrylate, trimethylolpropane triacrylate or trimethyolopropane trimethacrylate.

8. A composition according to any of the preceding claims wherein the polymerization initiator is 2,2-dimethoxy-2-phenylacetophenone, $C_1$-$C_5$ alkyl ether of benzoin, or benzophenone.

9. A composition according to any of the preceding claims characterised in that the tapered di-block copolymer has a single glass transition termperature below $0^\circ$ C.

10. A printing plate comprising a support and thereupon an elastomeric composition as claimed in any one of claims 1 to 9.

11. A process for forming a solvent soluble elastomeric printing relief which comprises the steps:
    (a) applying to a sheet support a layer of a photosensetive elastomeric composition comprising
       (i) a tapered di-block copolymer of a $C_8$-$C_{12}$ vinyl aromatic hydrocarbon and $C_4$-$C_6$ diene hydrocarbon;
       (ii) an ethylenically unsaturated photopolymerizable crosslinking agent; and
       (iii) an effective amount of an addition poliymerization initiator activatable by actinic radiation;
    (b) irradiating desired protions of the sheet formed in step (a) with ultraviolet light for a time sufficient to cure said desired portions of said sheet; and
    (c) removing the unexposed areas thereby forming a relief surface; characterised in that the vinyl aromatic hydrocarbon comprises 3.5 to 15% by weight of the tapered di-block copolymer thereby to provide a printing relief having a Shore A hardness of 42 or less.

12. A process according to claim 11 characterised in that the photosensitive, elastomeric composition is

9

applied to the sheet support by solvent casting.

13. A process according to claim 11 or claim 12 characterised in that the photosensitive, elastomeric composition is applied to the sheet support by extruding at an elevated temperature.

14. A process according to any of claims 11 to 13 characterised in that the photosensitive, elastomeric composition is applied to the sheet support by calendering.

**Revendications**

1. Composition élastomère comprenant :
   (i) un di-polymère en masse progressif non élastomère d'un hydrocarbure vinylique aromatique $C_8$-$C_{12}$ et d'un hydrocarbure diène $C_4$-$C_6$,
   (ii) un agent réticulant photopolymérisable à insaturation éthylénique, et
   (iii) une quantité efficace d'un initiateur de polymérisation par addition, activable par un rayonnement actinique ; caractérisée en ce que l' hydrocarbure vinylique aromatique est présent à raison de 3,5 à 15% en poids du di-polymère en masse progressif et en ce que ladite composition élastomère photopolymérisable,lorsqu'elle est durcie par une exposition à un rayonnement actinique à travers une diapositive porteuse d'une image contenant à la fois des zones sensiblement claire et opaque , produit des portions de la composition en dessous de la zone claire qui sont insolubles dans un hydrocarbure halogéné et qui ont une dureté de 42 ou moins Shore A.

2. Composition selon la revendication 1, caractérisée en que
   (i) ledit di-polymère en masse progressif représente au moins 70%
   (ii) ledit agent réticulant représente au moins 1% en poids, et
   (iii) ledit initiateur représente au moins 0,1% en poids, tout ce qui précède étant basé sur le poids total de la composition.

3. Composition selon la revendication 2, caractérisée en ce qu'elle contient de plus 1 à 5% d'une cire microcristalline et un copolymère.

4. Composition selon la revendication 2 ou 3, caractérisée en ce que le di-polymère en masse progressif a pour formule A-(A B)-B, un poids moléculaire moyen en nombre de 25.000 à 2.000.000, un indice de polydispersité de 1,5 à 4,0, une structure cis-1,4 d'au moins 29% et une structure 1,2-ne dépassant pas 15%.

5. Composition selon la revendication 3 ou 4, caractérisée en ce que l'hydrocarbure vinylique aromatique est du styrène, de l'alpha-méthylstyrène ou du vinyltoluène.

6. Composition selon l'une des revendications 3 à 5, caractérisée en ce que la dioléfine aliphatique conjuguée est du butadiène ou de l'isoprène.

7. Composition selon l'une quelconque des revendications précédentes, caractérisée en ce que l'agent réticulant photopolymérisable à insaturation éthylénique est 1,4-butanediol diacrylate, 1,4-butanediol diméthacrylate, 1,6-hexanediol diacrylate, 1,6-hexanediol diméthacrylate, triméthylolpropane triacrylate ou triméthylolpropane triméthacrylate.

8. Composition selon l'une quelconque des revendications précédentes, où l'initiateur de polymérisation est la 2,2-diméthoxy-2-phénylacétophénone, un alkyl éther $C_1$-$C_5$ de benzoïne ou la benzophénone.

9. Composition selon l'une quelconque des revendications précédentes, caractérisée en ce que le di-polymère en masse progressif a une seule température de transition vitreuse en dessous de $0°$ C.

10. Plaque d'impression comprenant un support et par-dessus une composition élastomère selon l' une quelconque des revendications 1 à 9.

11. Procédé de formation d'un relief d'impression en élastomère soluble dans un solvant qui comprend les étapes de :

(a) appliquer,à un support en feuille,une couche d'une composition élastomère photosensible comprenant

(i) un di-polymère en masse progressif d'un hydrocarbure aromatique vinylique $C_8$-$C_{12}$ et d'un hydrocarbure diène $C_4$-$C_6$ ;

(ii) un agent réticulant photopolymérisable à insaturation éthylénique ; et

(iii) une quantité efficace d'un initiateur de polymérisation par addition activable par un rayonnement actinique ;

(b) irradier des portions souhaitées de la feuille formée à l'étape (a) par de la lumière ultraviolette pendant un temps suffisant pour durcir lesdites portions souhaitées de ladite feuille ;

(c) enlever les zones non exposées pour ainsi former une surface en relief ; caractérisé en ce que l'hydrocarbure vinylique aromatique comprend 3,5 à 15% en poids du di-polymère en masse progressif pour ainsi former un relief d'impression ayant une dureté Shore A de 42 ou moins.

12. Procédé selon la revendication 11, caractérisé en ce que la composition photosensible élastomère est appliquée au support en feuille par coulage au solvant .

13. Procédé selon la revendication 11 ou la revendication 12, caractérisé en ce que la composition élastomère photosensible est appliquée au support en feuille par extrusion à une température élevée.

14. Procédé selon l'une quelconque des revendications 11 à 13, caractérisé en ce que la composition élastomère photosensible est appliquée au support en feuille par calandrage.

**Ansprüche**

1. Elastomere Zusammensetzung, die

(i) ein nicht-elastomeres konisches Diblockcopolymer aus einem vinylaromatischen $C_8$ - $C_{12}$ Kohlenwasserstoff und einem $C_4$ - $C_6$ Dienkohlenwasserstoff,

(ii) ein ethylenisch ungesättigtes photopolymerisierbares Vernetzungsmittel und

(iii) eine wirksame Menge eines durch aktinische Strahlung aktivierbaren Additionspolymerisationsinitiators umfaßt, **dadurch gekennzeichnet**, daß der vinylaromatische Kohlenwasserstoff in einer Menge von 3,5 bis 15 Gew.% des konischen Diblockcopolymeren vorhanden ist und daß die photopolymerisierbare elastomere Zusammensetzung, wenn sie durch Belichtung mit aktinischer Strahlung durch einen transparenten Bildträger mit sowohl im wesentlichen klaren als auch undurchsichtigen Bereichen gehärtet wird, unterhalb der klaren Bereiche Zusammensetzungsanteile liefert, die in halogeniertem Kohlenwasserstoff unlöslich sind und eine Shore-A-Härte von 42 oder weniger aufweisen.

2. Eine Zusammensetzung nach Anspruch 1, **dadurch gekennzeichnet**, daß - bezogen auf das Gesamtgewicht der Zusammensetzung -

(i) die Menge des konischen Diblockcopolymeren mindestens 70 % beträgt,

(ii) die Menge des Vernetzungsmittels mindestens 1 Gew.% beträgt und

(iii) die Menge des Initiators mindestens 0,1 Gew.% beträgt.

3. Zusammensetzung nach Anspruch 2, **dadurch gekennzeichnet**, daß sie außerdem 1 bis 5 % mikrokristallines Wachs und Copolymer enthält.

4. Zusammensetzung nach Anspruch 2 oder 3, **dadurch gekennzeichnet**, daß das konische Diblockcopolymer eine Formel A-(A B)-B, ein zahlenmäßiges durchschnittliches Molekulargewicht von 25.000 bis 2.000.000, einen Polydispersitätsindex von 1,5 bis 4,0 , eine cis-1,4-Struktur von mindestens 29 % und eine 1,2-Struktur von nicht mehr als 15 % aufweist.

5. Zusammensetzung nach Anspruch 3 oder 4, **dadurch gekennzeichnet**, daß der vinylaromatische Kohlenwasserstoff Styrol, alpha-Methylstyrol oder Vinyltoluol ist.

6. Zusammensetzung nach einem der Ansprüche 3 bis 5, **dadurch gekennzeichnet**, daß das aliphatische konjugierte Diolefin Butadien oder Isopren ist.

**7.** Zusammensetzung nach einem der vorangehenden Ansprüche, **dadurch gekennzeichnet**, daß das ethylenisch ungesättigte photopolymerisierbare vernetzungsmittel 1,4-Butandioldiacrylat, 1,4-Butandioldimethacrylat, 1,6-Hexandioldiacrylat, 1,6-Hexandioldimethacrylat, Trimethylolpropantriacrylat oder Trimethylolpropantrimethacrylat ist.

**8.** Zusammensetzung nach einem der vorangegangenen Ansprüche, in der der Polymerisationsinitiator 2,2-Dimethoxy-2-phenylacetophenon, $C_1$ - $C_5$ Alkylether von Benzoin oder Benzophenon ist.

**9.** Zusammensetzung nach einem der vorangehenden Ansprüche, **dadurch gekennzeichnet**, daß das konische Diblockcopolymer eine einzige Glasübergangstemperatur unterhalb 0 °C besitzt.

**10.** Druckplatte, die einen Träger und darauf eine elastomere Zusammensetzung gemäß einem der Ansprüche 1 bis 9 umfaßt.

**11.** Verfahren zur Bildung eines lösungsmittellöslichen elastomeren Druckreliefs, bei dem
(a) auf einen bogenförmigen Träger eine Schicht einer photosensitiven elastomeren Zusammensetzung aufgebracht wird, die
(i) ein konisches Diblockcopolymer aus einem vinylaromatischen $C_8$ - $C_{12}$ Kohlenwasserstoff und einem $C_4$ - $C_6$ Dienkohlenwasserstoff,
(ii) ein ethylenisch ungesättigtes photopolymerisierbares Vernetzungsmittel und
(iii) eine wirksame Menge eines durch aktinische Strahlung aktivierbaren Additionspolymerisationsinitiators umfaßt,
(b) gewünschte Bereiche des in Stufe (a) gebildeten Bogens ausreichend lange mit ultraviolettem Licht bestrahlt werden, um die gewünschten Bereiche des Bogens zu härten, und
(c) die nicht belichteten Bereiche unter Ausbildung einer Reliefoberfläche entfernt werden, **dadurch gekennzeichnet**, daß der vinylaromatische Kohlenwasserstoff 3,5 bis 15 Gew.% des konischen Diblockcopolymeren ausmacht und dadurch ein Druckrelief mit einer Shore A Härte von 42 oder weniger liefert.

**12.** Verfahren nach Anspruch 11, **dadurch gekennzeichnet**, daß die photosensitive elastomere Zusammensetzung auf den bogenförmigen Träger durch Lösungsmittelguß aufgebracht wird.

**13.** Verfahren nach Anspruch 11 oder 12, **dadurch gekennzeichnet**, daß die photosensitive, elastomere Zusammensetzung auf den bogenförmigen Träger durch Extrudieren bei erhöhter Temperatur aufgebracht wird.

**14.** Verfahren nach einem der Ansprüche 11 bis 13, **dadurch gekennzeichnet**, daß die photosensitive elastomere Zusammensetzung durch Kalandrieren aufgebracht wird.